# EUROPÄISCHE PATENTANMELDUNG

(11) **EP 1 653 240 A1**
(43) Veröffentlichungstag der Anmeldung: **03.05.2006**
(21) Anmeldenummer: 05023345.1
(22) Anmeldetag: 26.10.2005
(51) Int. Cl.: G01R 31/34, G06F 17/40, H02K 7/06

(54) **Linearantriebsvorrichtung**

(30) Priorität: 28.10.2004 CH 17792004
(71) Anmelder: AB SKF, S-415 50 Göteborg (SE)
(72) Erfinder: Jehle, Thomas, 79618 Rheinfelden (DE); Buchmann, Peter, 4419 Lupsingen (CH); Griner, Stefan, 4414 Füllinsdorf (CH)
(74) Vertreter: Klein, Friedrich Jürgen

(57) **Zusammenfassung**

Um bei Linearantriebsvorrichtungen mit einem elektrischen Antrieb eine verbesserte Möglichkeit der Feststellung von Versagensgründen zu erhalten sollen Betriebsdatenerfassungsmittel zur Erfassung von Daten im Zusammenhang mit über einen bestimmten Zeitraum erfolgenden Betriebsbelastungen und/oder eines Betriebszustandes des elektrischen Antriebs vorgesehen werden, wobei das Betriebsdatenerfassungsmittel zur Datenerfassung an die Stromanschlussmittel anschliessbar ist. Mittel zur Speicherung von Daten, die auf einer Vielzahl von nacheinander erfolgenden Messungen der gleichen Messgrösse basieren, ermöglichen die Erfassung und Auswertung von Daten über einen langen Zeitraum, vorzugsweise während der gesamten Lebensdauer der Linearantriebsvorrichtung. Die Messungen erfolgen während des Einsatzes der Linearantriebsvorrichtung (14), in dem sich diese jeweils in einem Lastzustand befindet.

## Beschreibung

Die Erfindung betrifft eine Linearantriebsvorrichtung zur Ausführung von im wesentlichen geradlinigen Verstellbewegungen entlang einer Linearachse über zumindest einen Teil eines vorgegebenen maximalen Hubes zwischen zwei Endpositionen, die mit einem elektrischen Antrieb versehen ist, dessen rotative Antriebsbewegung mittels Getriebemittel in translatorische Bewegungen transformierbar ist, sowie Betriebsdatenerfassungsmittel zur Erfassung einer über einen bestimmten Zeitraum erfolgenden Betriebsbelastung und/oder eines Betriebszustandes der Linearantriebsvorrichtung, wobei die Betriebsdatenerfassungsmittel zur Datenerfassung an Stromanschlussmittel des elektrischen Antriebs anschliessbar sind.

In vielen Bereichen der Technik werden Linearantriebsvorrichtungen eingesetzt, bei denen mit einem Elektromotor mit einer drehenden Welle über eine Getriebeeinrichtung ein Verbindungsteil linear, d.h. translatorisch, beweglich ist. Oftmals bilden hierbei Elektromotor, Getriebeeinrichtung und Verbindungsteil eine bauliche Einheit. Der Verbindungsteil ist dabei zwischen einem unteren und einem oberen Totpunkt beweglich, wobei selbstverständlich die Bezeichnung "unterer" und "oberer" Totpunkt nicht nur vertikale sondern jede beliebige Bewegungsrichtung erfassen soll.

In bestimmten Linearantriebsvorrichtungen, die für die vorliegende Erfindung von besonderer Bedeutung sind, weist die Getriebeeinrichtung eine Spindel mit einem Gewinde auf, entlang dem sich eine Spindelmutter bewegt. Die Spindelmutter wiederum befindet sich innerhalb eines Schubrohrs und ist mit diesem drehfest verbunden. Da auch der Verbindungsteil zur drehfesten Verbindung mit einer translatorisch zu bewegenden Last vorgesehen ist, wird die über den Elektromotor erzeugte rotatorische Antriebsbewegung der Spindel in eine rein translatorische Vorschubbewegung der Spindelmutter und damit auch des Schubrohrs transformiert.

Derartige Antriebe werden oftmals in sicherheitssenslilven Anwendungen eingesetzt, wie beispielsweise in Patientenbetten, Patientenlifter, Operationstischen, Verstelleinrichtungen zur Positionierung von Röntgengeräte und dergleichen. Insbesondere für derartige Einsatzbereiche ist es dringend erforderlich, dass die Linearantriebsvorrichtung gemäss den von seinem Hersteller vorgegebenen Einsatzbedingungen verwendet wird, damit keine Überbeanspruchungen - sowohl des Motors als auch der Mechanik - auftreten, die zu einem Versagen der Linearantriebsvorrichtung führen. Ein Versagen der Linearantriebsvorrichtung kann eine Gefährdung von Gesundheit und Leben von Personen sowie eine Beschädigung von teuren technischen Anlagen zur Folge haben. Es besteht deshalb häufig das Bedürfnis, nach einem Versagen einer Linearantriebseinrichtung den Grund des Versagens festzustellen, Dies wird bis anhin durch eine Untersuchung der Linearantriebsvorrichtung vorgenommen. Allerdings kann man aufgrund der Versagensspuren oftmals nicht eindeutig auf die Gründe des Versagens zurückschliessen.

Aus dem Bereich der Produktion von Elektromotoren ist eine Vorrichtung und ein Verfahren bekannt, durch die auch ohne aufwendige Motorenprüfstände Leistungsdaten eines Elektromotors innerhalb der Produktionsumgebung ermittelbar sein sollen. So wird in der US 6,577,137 B1 vorgeschlagen, von einem nicht an eine Last angeschlossenen Elektromotor Daten über den von ihm aufgenommenen Strom und die Drehzahl innerhalb eines bestimmten Zeitintervalls aufzunehmen. Anhand diesen Messungen werden Leistungsdaten des Motors ermittelt, insbesondere sein Anlaufmoment. Die hiermit ermittelbaren Daten können jedoch keine Auskunft über Gründe eines möglichen Versagens des Motors geben, den er in einem späteren bestimmungsgemässen Einsatz möglicherweise erleidet.

Aus dem Bereich der automobilen Fahrwerks-/Lenktechnik sind durch die US 5,912,539 Vorrichtungen bekannt, die während des Einsatzes eines Fahrzeuges prüfen, ob abnormale Werte des Motorstroms von einer elektrischen Lenkung vorhanden sind. Werden solche abnormalen Werte festgestellt, schaltet die Vorrichtung ein mit einem Linearantrieb versehenes Hillsaggregat zu, das die Lenkkraft erhöhen soll. Auch diese Lösung kann nicht dazu beitragen nach einem Versagen des Linearantriebs genauere Aussagen über die Versagensgründe treffen zu können.

Der Erfindung liegt deshalb die Aufgabe zugrunde für gattungsgemässe Linearantriebsvorrichtungen eine verbesserte Möglichkeit zur Feststellung von Versagensgründen zu schaffen.

Die Aufgabe wird bei einer Linearantriebsvorrichtung der eingangs genannten Art erfindungsgemäss mit Mitteln zur Speicherung von Daten gelöst, wobei die Daten auf einer Vielzahl von nacheinander erfolgenden Messungen der gleichen Messgrösse basieren, und wobei die Messungen während des Einsatzes der Linearantriebsvorrichtung an einer Last, vorzugsweise im wesentlichen während der gesamten Lebensdauer der Vorrichtung, erfolgen. Die Aufgabe wird zudem durch ein Verfahren gemäß Patentanspruch 22 gelöst.

Der Erfindung liegt die Erkenntnis zugrunde, dass sich mechanische Überbelastungen von Linearantriebsvorrichtungen, die möglicherweise zu einem späteren Zeitpunkt zu einem Versagen oder zu einer sonstigen Beeinträchtigung führen, anhand von physikalischen Werten oder in Form der Häufigkeit von Ereignissen bereits zum Zeitpunkt der Überbeanspruchung messen lassen. Dies gilt sowohl bei im wesentlichen einmaligen Überbelastungen als auch bei solchen, die sich durch eine unzulässig hohe Dauerbeanspruchung ergeben. Im Rahmen der Erfindung wurde festgestellt, dass sich insbesondere bei Linearantriebsvorrichtungen mit einer drehenden Spindel und einer sich durch ein Getriebe vorgenommenen Transformierung der rotativen Antriebsbewegung in eine translatorische Bewegung, Daten über Beanspruchungen der Vorrichtung besonders einfach am elektrischen Motor bestimmen lassen. Der mit einem erfindungsgemässen Betriebsdatenerfassungsmittel versehene gattungsgemässe Elektromotor kann aber grundsätzlich auch in völlig anderen Anwendungen verwendet werden, als in den genannten Linearantriebsvorrichtungen. Auch in anderen Anwendungen können auf diese Weise Betriebsdaten bezüglich Betriebsbeanspruchungen erfasst und damit auf und einen bestehenden Verschleisszustand der jeweiligen Vorrichtung geschlossen werden.

Es hat sich gezeigt, dass durch die Erfassung von bestimmten, vom Elektromotor direkt oder indirekt abhängigen, Messgrössen, sich sehr genau auf Spitzen- und/oder Dauerbelastungen der jeweils gesamten Linearantriebsvorrichtung schliessen lässt. Hierdurch liegen unter anderem bei Produkthaftungsfällen bessere Hinweise für die Frage vor. ob der Hersteller der Linearantriebsvorrichtung haftbar ist, oder ob ein unzulässiger Einsatz der Linearantriebsvorrichtung vorliegt. Im praktischen Einsatz dürfte aber deutlich häufiger eine sich aus der Erfindung in sehr vorteilhafter Weise auch ergebende Möglichkeit an Bedeutung gewinnen. Demnach kann der Hersteller aufgrund erfindungsgemässer Massnahmen nun nachweisen, ob bei einer Beschädigung der Vorrichtung für ihn ein Garantiefall vorliegt, oder ob ein Versagen der Linearantriebsvorrichtung auf eine nicht vorschriftsgemässe Verwendung zurückzuführen ist.

In einer bevorzugten Ausführungsform der Erfindung kann mit den Erfassungsmitteln für die Betriebsbelastung eine über einen bestimmten Zeitraum erfolgte Gesamteinsatzzeit der Linearantriebsvorrichtung erfasst werden. Hierzu kann die Dauer der einzelnen Betriebseinsätze gemessen und zu jeweils der Summe der Dauer der vorhergegangenen einzelnen Betriebseinsätze des elektrischen Antriebs bzw. der Linearantriebsvorrichtung addiert werden. Dies ermöglicht unter anderem zu ermitteln, ob bereits innerhalb der Garantiezeit für eine Linearantriebsvorrichtung ihre zugesicherte Lebensdauer überschritten ist.

Diese Ausgestaltung ermöglicht - ebenso wie nahezu alle anderen bevorzugten Ausführungsformen der Erfindung - aber auch auf eine deutlich genauere und einfachere Weise als bisher das Erreichen von vorgeschriebenen Wartungsintervallen zu bestimmen. Es wird nun beispielsweise möglich, aufgrund eines tatsächlich erfolgten Benutzungsumfangs auf das Erreichen eines Wartungsintervalls oder auf das Lebensdauerende hinzuweisen. Hierzu kann beispielsweise ein akustisches oder optisches Signal ausgegeben werden, oder aber auch an den Wartungsdienst des Herstellers des Antriebs eine E-Mail oder eine SMS-Nachricht automatisch abgesandt werden. Da auch die Einhaltung von vorgeschriebenen Wartungsintervallen erheblich zur Vermeidung eines vorzeitigen Versagens der Vorrichtung beiträgt, kann hiermit ebenfalls die Sicherheit deutlich gesteigert werden.

Im wesentlichen die gleichen Vorteile können bei weiteren bevorzugten Ausführungsformen durch Mittel erreicht werden, mit denen die Anzahl an Starts der Linearantriebsvorrichtung erfassbar sind.

In einer weiteren Ausführungsform der Erfindung können die Temperaturen gemessen werden, unter denen der Antrieb eingesetzt wurde. Hierbei können sowohl Spitzentemperaturen und/oder auch der Temperaturverlauf über bestimmte Zeiträume gemessen werden. Des weiteren kann es zweckmässig sein, Gesamtbetriebszeiten der Linearantriebsvorrichtung über einen oder mehrere Temperaturgrenzwerte zu erfassen. Unzulässig hohe Temperaturen können den Antrieb beschädigen und zu dessen Versagen führen. Temperaturen, insbesondere das Überschreiten vorbestimmter Grenztemperaturen, können beispielsweise mittels einem Komparator bestimmt werden.

Zu einer Verbesserung der Genauigkeit der Rückschlüsse auf die tatsächlichen Versagensgründe kann beitragen, wenn in einer vorteilhaften erfindungsgemässen Ausführungsform mehrere physikalische Grössen und/oder Ereignisse bestimmt werden. Durch eine Gesamtbetrachtung mehrerer Grössen und/oder Ereignisse kann erreicht werden, dass bei Messfehlern von einer Grösse, oder falls aus sonstigen Gründen die Werte einer Grässe (alleine) nicht aussagekräftig sind, trotzdem auf den Beanspruchungszustand der Linearantriebsvorrichtung geschlossen werden kann.

In einer weiteren bevorzugten Ausgestaltung kann bei zumindest einigen der gemessenen Grössen und/oder Ereignissen zwischen den beiden Drehrichtungen der Abtriebswelle bzw. den beiden Belastungsrichtungen zum oberen bzw, zum unteren Totpunkt der Vorrichtung unterschieden werden. Dies kann insbesondere bei Anwendungen zu einer Verbesserung der Genauigkeit der Auswertung führen, bei denen in eine Bewegungsrichtung in der Regel eine höhere Belastung vorliegt als in die andere Bewegungsrichtung. Dies ist beispielsweise bei Linearantriebsvorrichtungen üblicherweise der Fall, mit denen eine Last angehoben werden soll, wie beispielsweise bei OP-Tischen oder Patientenbetten.

Der elektrische Antrieb bzw. die Linearantriebsvorrichtung sollte Speichermittel, wie beispielsweise nicht flüchtige elektronische Speichermittel, zur Abspeicherung über einen längeren Zeitraum von Daten bereits erfolgter Messungen aufweisen. Die Vorrichtung kann in einer zweckmässigen Weiterbildung mit einer Schnittstelle versehen sein, über die die gespeicherten Werte ausgelesen und gegebenenfalls auch Daten in umgekehrter Richtung eingelesen werden können. Derartige Schnittstellen und Speichermittel sind insbesondere aus dem Bereich der Datentverarbeitung vielfach vorbekannt.

In einer bevorzugten erfindungsgemässen Ausgestaltung kann die Schnittstelle mit einer optischen Anzeige, wie beispielsweise mit einer oder mehreren Leuchtdioden(LED) versehen sein. Die optische Anzeige kann beispielsweise in Abhängigkeit von den bereits erfolgten Benutzungen und den dabei aufgetretenen quantitativen und/oder qualitativen Belastungen Grün, Orange oder Rot aufleuchten. Grün signalisiert hierbei, dass das nächste Wartungsintervall oder das Lebensdauerende der Vorrichtung noch deutlich nicht erreicht ist. Orange warnt vor dem nahen Ende und Rot signalisiert, dass das Wartungsintervall bzw. das Lebensdauerende bereits überschritten ist.

In einer vorteilhaften Weiterbildung der Erfindung können bereits abgespeicherte Werte über die optische Anzeige wiedergegeben werden. Bei einer oder mehreren LED's kann dies beispielsweise durch unterschiedlich lange aufleuchtende Blinksignale der LED vorgenommen werden. Die Daten werden hierbei in entsprechende Lichtsignale moduliert. Derartige Modulationsverfahren sind vorbekannt und können von einem Mikrocontroller ausgeführt werden, der in zweckmässiger Weise in der Messeinrichtung auch andere Funktionen übemimmt. Durch geeignet schnelle Blinksignale kann erreicht werden, dass das Blinken vom menschlichen Auge nicht wahrgenommen wird. Mittels einem optischen Sensor, den beispielsweise Wartungspersonal mit sich tragen kann, können die Daten dann berührungslos erfasst und anschliessend in eine lesbare und/oder speicherbare Form transformiert und soweit dies noch nicht erfolgt ist, auch ausgewertet werden.

Eine solche bevorzugte Ausgestaltung hat den Vorteil, dass die Daten berührungslos weitergegeben werden können. Zudem können Daten nur in einer Richtung fliessen, wodurch die Datenerfassung besonders manipulationssicher wird. Selbstverständlich kann in anderen Ausführungsformen die Schnittstelle auch Datenverkehr in beide Richtungen zulassen. Ebenso können andere Datenübermittlungsverfahren als optische Verfahren vorgesehen sein.

Der elektrische Antrieb bzw. die erfindungsgemässe Linearantriebsvorrichtung kann mit einer Auswerteeinrichtung zu einem System kombiniert werden, mit dem die gemessenen Werte und/oder erfassten Ereignisse in vorbestimmter Weise bzw. nach vorbestimmten Regeln typenabhängig auswertbar sind. Hierzu können die ausgelesenen Daten einem Datenverarbeitungsprogramm der Auswerteeinrichtung zugeführt werden, in dem Auswerteregeln in Form von Programmcode niedergelegt bzw. definiert sind. Hierbei sollen aus den über einen längeren Zeitraum erfolgten Messdaten Parameter bestimmt werden, die von dem in der Vergangenheit erfolgten Benutzungsumfang und/oder von der Belastungshöhe bzw. dem bereits eingetretenen Verschleisszustand abhängig sind. Die Auswerteeinrichtung kann dauerhaft mit der Linearantriebsvorrichtung verbunden sein oder aber über die Schnittstelle an die Linearantriebsvorrichtung beliebig oft anschliessbar und wieder abtrennbar sein.

So kann beispielsweise vorgesehen sein, die totale Zeit zu messen, die für sämtliche Aufwärtsfahrten einerseits und die totale Zeit, die für sämtliche Bewegungen in die andere Richtung benötigt wurde. Mit der Auswerteeinheit kann dann das Verhältnis aus den benötigten Zeiten für die beiden Bewegungsrichtungen bestimmt werden. Dieses Verhältnis gibt Auskunft über die Höhe der Belastung. Je höher ein Antrieb belastet wird, desto mehr Zeit benötigt er, für einen bestimmten Weg. Übersteigt das Verhältnis einen bestimmten Grenzwert so kann auf eine konstante Überbelastung des Antriebs in eine Bewegungsrichtung geschlossen werden.

In einer weiteren vorteilhaften Ausgestaltung der Erfindung kann die Anzahl der von der Linearantriebsvorrichtung ausgeführten Doppelhübe bestimmt werden. Hierbei wird angenommen, dass die benötigte Bewegungszeit in die Bewegungsrichtung, die der Wirkrichtung der zu bewegenden Last entspricht (Lastrichtung), unabhängig von der Belastung ist. Hingegen ist die Bewegungszeit in die Bewegungsrichtung, die der Gewichtskraft der zu bewegenden Last entgegen wirkt (Lastgegenrichtung), von der Höhe der Belastung abhängig ist. Da der maximale Hub der Vorrichtung bekannt ist, kann errechnet werden, wie oft die Vorrichtung den Weg der maximalen Doppelhübe abgefahren hat. Die Anzahl der Doppelhübe kann ein Mass für den Verschleiss- oder Belastungszustand der Linearantriebsvorrichtung sein.

Wird die maximale Einschaltzeit in eine Bewegungsrichtung, in der regelmässig höhere Belastungen auftreten, gemessen, so kann dies Informationen über die grösste Last bzw. maximale Belastung geben, falls angenommen wird, dass hierbei auch der maximale Hub abgefahren wurde. Da die Länge des maximalen Hubs sowie die bei der grössten zulässigen Last für den maximalen Hub benötigte Zeit bekannt sind, kann daraus auch bestimmt werden, ob der Antrieb zumindest einmal überbelastet wurde.

Es können ferner Mittel vorhanden sein, mit denen die maximale Einschaltzeit in eine Bewegungsrichtung bestimmt wird, in der in der Regel eine geringere Belastung (Lastrichtung) vorliegt als in die andere Bewegungsrichtung. Unter der Annahme, dass der maximale Hub abgefahren wurde, kann man hierdurch Auskunft über den tatsächlich maximal abgefahrenen Hub erhalten.

Sind in einer Ausführungsform Mittel vorhanden, die gesamten Zeiten für beide Fahrtrichtungen getrennt voneinander zu bestimmen, so kann auf die durchschnittliche Dauer einer Fahrt für hin und zurück geschlossen werden.

Von Vorteil kann auch sein, wenn Mittel vorhanden sind, um Überspannungen des Motors zu bestimmen. Wird keine Überspannung festgestellt, so kann darauf geschlossen werden, dass der Antrieb mit einer für ihn vorgesehenen Steuerung betrieben wurde. Treten Überspannungen nur in Lastrichtung auf, liegt vermutlich ein weicher Trafo vor. Treten hingegen in beide Bewegungsrichtungen Überspannungen auf, so wurde der Antrieb vermutlich mit einer vom Hersteller des Antriebs nicht zugelassenen bzw. mit einer ungeeigneten Steuerung betrieben.

Stehen zur Auswertung auch Temperaturwerte des elektrischen Antriebs zur Verfügung so kann durch einen Vergleich mit zulässigen Temperaturwerten festgestellt werden, ob unzulässig hohe Temperaturen vorliegen und dadurch auf eine eventuelle Überlastung des Antriebs geschlossen werden. Zu hohe Temperaturen können beispielsweise durch eine zu lange Einschaltzeit des Antriebs entstehen. Insbesondere ist ein längerer Betrieb des Antriebs über eine bestimmte Grenztemperatur ein Indiz dafür, dass der Antrieb für die zu bewegende Last zu schwach ist und somit ein konstruktiver Auslegungsfehler des Anwenders der Linearantriebsvorrichtung vorliegt.

In der Auswerteeinheit können auch Regeln in Form von Programmcode abgelegt sein, die bereits erfolgte Benutzungen der Vorrichtung berücksichtigen und ständig bzw. in bestimmten oder in bedarfsbestimmten Intervallen die voraussichtlich noch zur Verfügung stehende Rest-Lebensdauer bzw. Rest-Benutzungsdauer bis zur nächsten Wartung ermittelt. Hierbei können sowohl die Quantität als auch die Qualität erfolgter Benutzungen oder Beanspruchungen berücksichtigt werden. Unzulässig hohe Beanspruchungen können zu einer extrem starken Verkürzung der Rest-Lebensdauer bzw. der Rest-Benutzungsdauer führen.

Weitere bevorzugte Ausführungsformen ergeben sich aus den Ansprüchen, der Beschreibung sowie den Figuren.

Die Erfindung wird anhand von in den Figuren rein schematisch dargestellten Ausführungsbeispieien näher erläutert, es zeigen:
- Fig.1: eine teilweise geschnittene perspektivische Darstellung eines erfindungsgemäßen Linearantriebs;
- Fig. 2: eine schematische Darstellung der Schaltung der Elektromotoren von zwei Linearantriebsvorrichtungen und ihre elektrische Versorgung sowie Messeinrichtungen für jeden Elektromotor zur Erfassung von Belastungszuständen der Elektromotoren;
- Fig. 3: ein Schaltbild einer Messeinrichtung zur Erfassung von Parametern des Elektromotors;
- Fig. 4: eine Zeiterfassung durch einen Mikrocontroller der Messeinrichtung;
- Fig. 4a: eine schematische Darstellung zum Messvorgang;
- Fig. 5: einen Zähler des Mikrocontrollers;
- Fig. 6: einen Komparator des Mikrokontrollers;
- Fig. 7a: Teil der Schaltung von Fig. 3 gezeigt, mit dem der Speichervorgang ausgelöst wird;
- Fig. 7b: einen Teil der Schaltung von Fig. 3 mit dem die Drehrichtung des Motors erkennbar ist;
- Fig. 7c: einen Teil der Schaltung von Fig. 3, mit dem eine Überspannung detektierbar ist;
- Fig. 7d: einen Teil der Schaltung von Fig. 3, mit dem Temperaturgrenzwerte detektierbar ist;

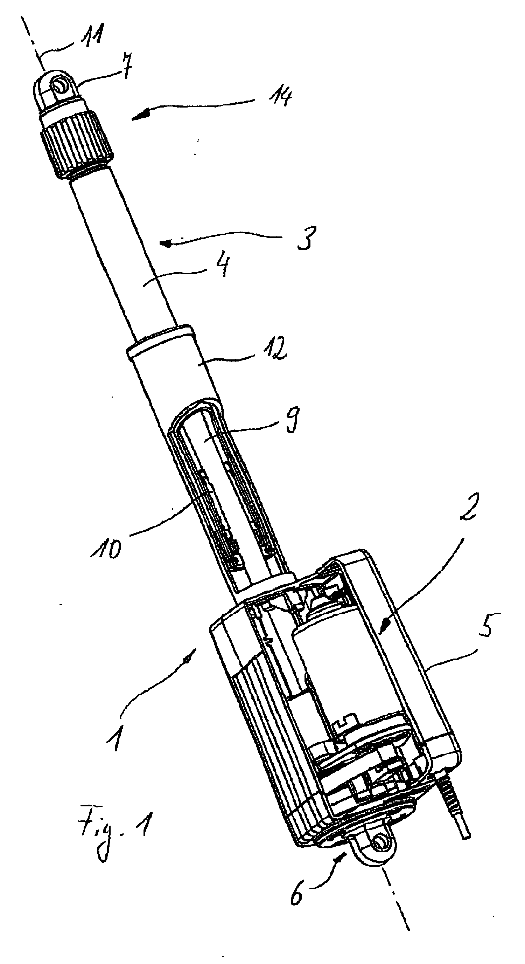

In Fig. 1 ist ein Beispiel für eine Linearantriebsvorrichtung gezeigt. Diese weist auf einer Antriebsseite 1 als elektrischen Antrieb einen Gleichstrommotor 2 auf, mit dessen rotativer Antriebsbewegung eine Längsbewegung eines auf einer Antriebsseite 1 vorgesehenen Schubrohres 4 bewirkt wird. An einem Gehäuse 5 des Gleichstrommotors 2 ist ein antriebsseitiger Gabelkopf 6 vorgesehen, mit dem der Linearantrieb in eine Anlage, medizinisches Inventar, ein Möbel, eine Maschine oder dergleichen, befestigt werden kann. Hauptsächliche Anwendungsfälle für diesen Linearantrieb sind Patientenbetten, Operationstische, Lifter, insbesondere Patientenlifter, und ähnliches.

Eine Rotationsbewegung einer Motorwelle wird auf eine Spindel 9 übertragen. die ein nicht selbsthemmendes oder ein selbsthemmendes Aussengewinde aufweisen kann. Um die Rotationsbewegung des Motors ins Langsame zu transformieren, kann zwischen dem Motor 2 und der Spindel 9 ein Untersetzungsgetriebe, insbesondere ein zusätzliches Zahnradgetriebe wie beispielsweise ein Planetengetriebe, zwischengeschaltet sein.

Auf der Spindel 9 befindet sich eine Gewindemutter 10. Sowohl die Spindel 9 mit ihrem Aussengewinde als auch die Gewindemutter 10 mit ihrem Innengewinde sind Bestandteil eines Getriebes, mit dem die rotative Antriebsbewegung des Motors 2 in eine translatorische Nutzbewegung der Linearantriebvorrichtung transformiert wird. Die Gewindemutter 10 ist mit dem Schubrohr 4 verbunden und gegenüber der Spindel 9 drehfest angeordnet. Das Schubrohr 4 kann hierdurch entlang einer Längsbewegungsachse 11 aus einem Mantelrohr 12 ein- und ausgefahren werden. Sowohl die Spindel 9, die Gewindemutter 10, das Mantelrohr 12, als auch das Schubrohr 4 sind konzentrisch zur Längsbewegungsachse 11 1 angeordnet, die gleichzeitig auch Rotationsachse der Spindel 4 ist. Die Längsbewegung des Schubrohres 4 erfolgt aufgrund einer Drehbewegung der Spindel 9, die in an sich vorbekannter Weise in eine translatorische Bewegung der Gewindemutter 10 umgesetzt wird. Diese translatorische Bewegung wird vom Schubrohr 4 über eine als Verbindungsteil vorgesehenen weiteren Gabelkopf 7 auf eine nicht näher dargestellte, am Gabelkopf 7 befestigbare, Last übertragen.

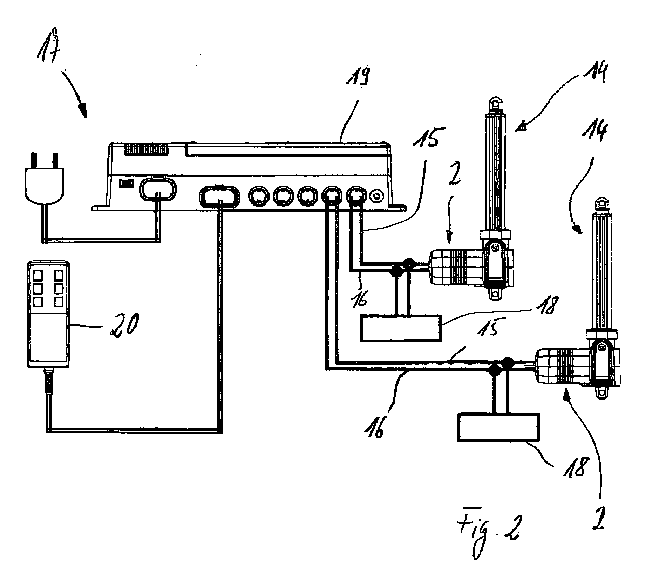

Da in Anwendungen auch oftmals mehr als eine Linearantriebsvorrichtung benötigt werden, sind in Fig. 2 zwei identische der in Fig. 1 gezeigten Linearantriebsvorrichtung 14 dargestellt. Die mehreren Linearantriebsvorrichtungen 14 können an dieselbe Steuerung 19 angeschlossen sein. Nachfolgend wird der weitere Aufbau der Linearantriebsvorrichtungen jedoch nur jeweils anhand von einer der beiden Linearantriebsvorrichtungen 14 erläutert.

An zwei Antriebsleitungen 15, 16 einer elektrischen Versorgung 17 des Motors 2 ist ein in den Fig. 2 - 7d stark schematisiert gezeigtes Betriebsdatenerfassungsmittel 18 angeschlossen. Prinzipiell könnte das Betriebsdatenerfassungsmittel 18 auch einer anderen Stelle zwischen der elektrischen Versorgung 17 und dem Motor 2 angeordnet bzw. angeschlossen sein, beispielsweise innerhalb des Motorengehäuses oder innerhalb der Linearantriebsvorrichtung 14. Die Elektronik des Betriebsdatenerfassungsmittels 18 wird von der elektrischen Versorgung 17 des Motors 2 mit Strom versorgt. Da die Stromaufnahme des Betriebsdatenerfassungsmittels 18 vernachlässigbar gering ist gegenüber der Stromaufnahme des Motors 2 wird hierdurch die Stromversorgung des Motors 2 nicht spürbar beeinträchtigt.

Die elektrische Versorgung 17 ist mit einer Steuerung 19 versehen, mit der der Motorstrom steuerbar ist. Über eine als Fernbedienung 20 ausgebildete Bedieneinrichtung können der Steuerung 19 hierzu entsprechende Steuerungssignale zugeführt werden.

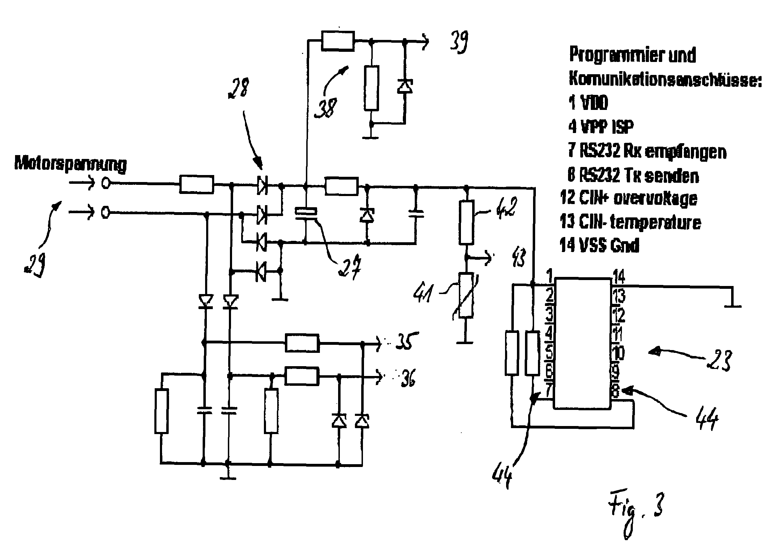

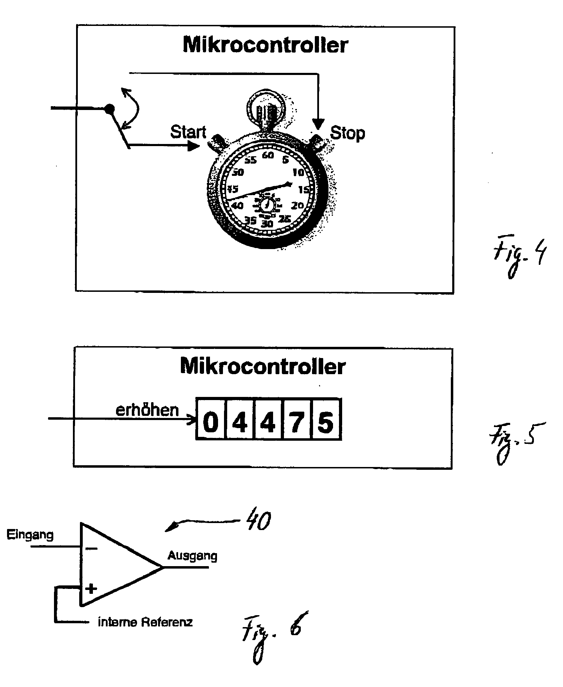

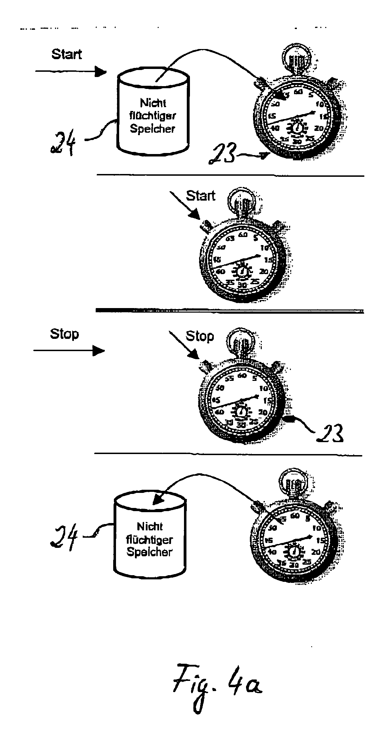

Das Betriebsdatenerfassungsmittel 18 weist einen in Fig. 3 gezeigten Mikrocontroller 23 sowie eine zwischen den Antriebsleitungen 15, 16 und dem Mikrocontroller 23 zwischengeschaltete Schaltung auf, mit der eingehende Signale (Motorspannung) aufbereitet und dann einem der Eingänge des Mikrocontrollers 23 zugeführt werden. Mit dem Mikrocontroller 23 können zumindest unterschiedliche Zeiten gemessen sowie das Auftreten bestimmter Ereignisse festgestellt werden, wie dies durch die Fig. 4 und 5 angedeutet ist. Hierbei können unterschiedliche Vorgänge die Zeitmessung starten bzw. stoppen.

Wie im oberen Teil von Fig. 4a angedeutet ist, wird bei einem die Datenerfassung auslösenden Startereignis vom Mikrocontroller 23 der aufgrund der vorausgegangenen Messung im Speicher 24 abgelegte Wert Zur gleichen Messgrösse ausgelesen. Als Startereignis kommen beispielsweise der Beginn einer Bewegung des Schubrohrs in eine der beiden möglichen Bewegungsrichtungen, ein Überschreiten eines Grenzwertes der Motorspannung oder der Temperatur in Frage. Zudem startet nun die Messung bzw. Datenerfassung. Sobald ein Stoppereignis eintritt, wie beispielsweise ein Stoppen der Antriebsbewegung, ein Unterschreiten der Motorspannung oder Temperatur, endet die Messung. Das Messresultat wird dann vom Mikrocontroller im nichtflüchtigen Speicher 24 abgelegt. Stehen Messdaten in keinem unmittelbaren Zusammenhang von bereits zuvor erfassten Messdaten, so kann auch das Auslesen des zuletzt abgelegten Messwertes der jeweiligen Messgrösse unterbleiben. Für diese Fälle kann beispielsweise vorgesehen sein, dass für jede Messung ein oder mehrere Werte separat und unabhängig von anderen Messwerten im Speicher 24 abgelegt werden.

Vorzugsweise werden sämtliche gemessene Zeiten zu bereits gemessenen Zeiten des gleichen Vorgangs aufaddiert. Ebenso wird der Summenwert der Anzahl gemessener bestimmter Ereignisse jeweils um eins erhöht, sobald der entsprechende Ereignistyp wieder auftritt. Dies ist in den beiden Fig. 4 und 5 angedeutet. Mit dem jeweils so ermittelte Summenwert wird der im nicht-flüchtigen Speicher 24 des Mikrocontrollers 23 abgelegte jeweils vorhergehende Summenwerte überschrieben. Zudem kann vorgesehen sein, den zu einem bestimmten Vorgangstypen bestimmten grössten einzelnen Zeitwert als solchen abzuspeichern. Der Mikrocontroller 23 ist in der Lage mehrere solcher Ereignistypen auf die beschriebene Weise zu verarbeiten.

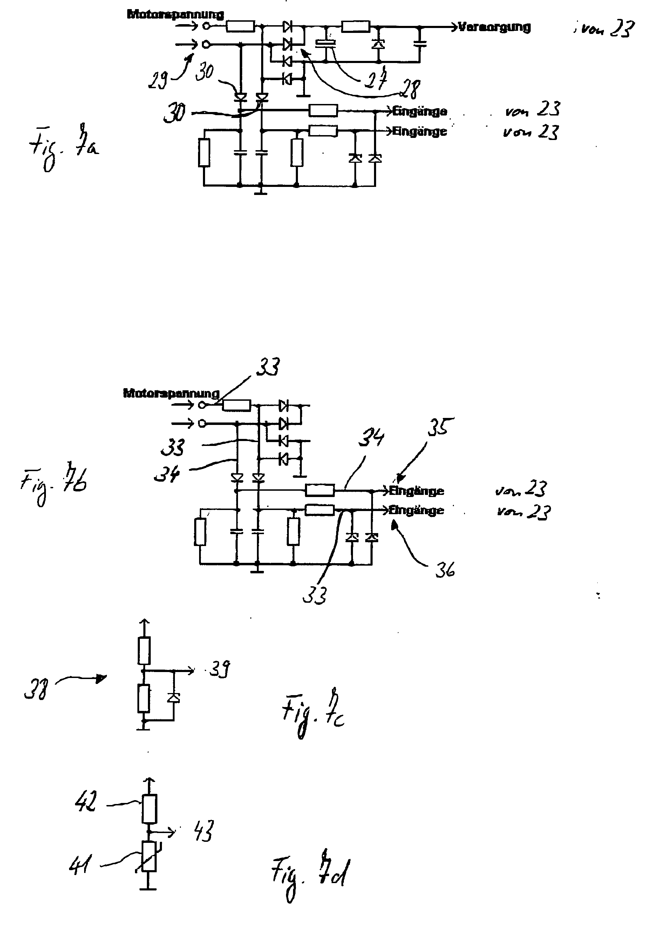

Der Mikrocontroller 23 ist ferner mit zwei Eingängen eines internen Komparators (Fig. 6) versehen, die beide mit einer internen Referenzspannung verglichen werden können.

In den Fig. 3 und Fig. 7a - 7d ist das Schaltschema des Betriebsdatenerfassungsmittels 18 wiedergegeben, das von der Motorspannung abgeleitete Daten mittels dem Mikrocontroller 23 erfasst. Die Sicherung der Daten wird durch ein plötzliches Ausbleiben der Versorgungsspannung an einem oder mehreren Eingängen des Controllers 23 ausgelöst. Die Versorgungsspannung bricht beispielsweise dann ab, wenn der elektrische Antrieb der Linearantriebsvorrichtung von einem Benutzer via einem nicht näher dargestellten Handschalter abgeschaltet wird. Die Spannungsversorgung des Controllers 23 selbst wird durch eine genügend gross dimensionierte Kapazität 27 sicher gestellt, die während des Betriebs der Linearantriebsvorrichtung aufgeladen wird. Nach Wegbleiben der Versorgungsspannung der Linearantriebsvorrichtung kann die Kapazität 27 den Controller 23 ausreichend lange mit Elektrizität versorgen, um die gesammelten Daten zu speichern.

In Fig. 7a ist der Teil der Schaltung von Fig. 4 gezeigt, mit dem der Speichervorgang ausgelöst wird. Wie hier dargestellt ist, wird die Versorgung durch die Kapazität 27 gestützt und durch den Gleichrichter 28 vom Eingang 29 abgekoppelt. Die im Kondensator 27 gespeicherte Energie wird bei Wegfall der Versorgungsspannung für den Speichervorgang der Daten in einen nicht flüchtigen Speicher (Fig. 4a) des Controllers 23 benötigt. Mit den beiden Dioden 30 wird bei Wechsel der Polarität am Motor entweder die eine oder die andere Diode 30 leitend und somit die Information über die Richtung und ein Vorhandensein einer Versorgungsspannung an den Controller 23 weitergeleitet.

Fig. 7b zeigt den Teil der Schaltung von Fig. 4 mit dem die Drehrichtung des Motors und damit auch die jeweilige Laufrichtung erkannt wird. Die für die Richtungserkennung wichtigen Pfade sind mit 33 und 34 bezeichnet. Die Schaltung bewirkt, dass je nach Drehrichtung des Motors nur an einem vorbestimmte Eingang der beiden Eingänge 35, 36 des Prozessors ein Eingangssignal anliegt. Wechselt die Drehrichtung des Motors, so steht dann auch am jeweils anderen der beiden Eingänge 35, 36 das Signal an, das der Drehrichtung des Motors entspricht.

Eine Überspannungserkennung wird durch den in Fig. 7c gezeigten Spannungsteiler 38 verwirklicht, der dem Controller 23 an seinem Eingang 39 eine analoge Spannung zur Verfügung stellt, die um einen Faktor kleiner ist als die tatsächlich anliegende Spannung. Der Spannungswert wird im Controller mittels einem Komparator 40 (Fig. 6) mit einem Referenzspannungswert verglichen und bei Überschreiten der Referenzspannung als Überspannung detektiert.

Die Temperatur wird durch den in Fig, 7d dargestellten temperaturveränderlichen Widerstand 41 erfasst, der analog zu seiner Umgebungstemperatur den Widerstandswert verändert. Der temperaturveränderliche Widerstand 41 ist mit einem weiteren Widerstand 42 in Serie geschaltet und bildet hierdurch einen Spannungsteiler. Diese Schaltung liefert an den Eingang 43 des Controllers eine Spannung, deren Wert sich mit dem Wert der Temperatur verändert. Mit einer controllerinternen Komparatorschaltung (beispielsweise Fig. 6) wird der Spannungswert, der von den in Serie geschalteten Widerständen 41, 42 erzeugt wird, mit einer Referenzspannung verglichen. Erreicht oder überschreitet die analoge Spannung den Wert der Referenzspannung, so springt der Komparatorausgang auf logisch 1, oder im invertierten Fall auf logisch 0. Mit diesem Schaltungsteil können durch Wechsel der Referenzspannung auch verschiedene Temperaturgrenzwerte erfasst werden.

Sämtliche über die Eingänge des Mikrocontrollers 23 anstehenden Spannungswerte werden vom Mikrocontroller digitalisiert und gegebenenfalls weiterverarbeitet. Die dann in einem nicht-flüchtigen Speicher abgelegten Daten können über eine Schnittstelle 44 ausgelesen werden.

### Bezugszelchenliste

- 1: Antriebsseite
- 2: Gleichstrommotor
- 4: Schubrohr
- 5: Gehäuse
- 6: Gabelkopf
- 7: Gabelkopf
- 9: Spindel
- 10: Gewindemutter
- 11: Längsbewegungsachse
- 12: Mantelrohr
- 14: Linearantriebsvorrichtung
- 15: Antriebsleitung
- 16: Antriebsleitung
- 17: elektrische Versorgung
- 18: Betriebsdatenerfassungsmittel
- 19: Steuerung
- 20: Fernbedienung
- 23: Mikrocontroller
- 24: Speicher
- 27: Kapazität
- 28: Gleichrichter
- 29: Eingang
- 30: vertikale Dioden
- 33: elektrischer Pfad
- 34: elektrischer Pfad
- 35: Eingang
- 36: Eingang
- 38: Spannungsteiler
- 39: Eingang
- 40: Komparator
- 41: Widerstand
- 42: Widerstand
- 43: Eingang
- 44: Schnittstelle

## Patentansprüche

1. Linearantriebsvorrichtung zur Ausführung von im wesentlichen geradlinigen Verstellbewegungen entlang einer Linearachse (11) über zumindest einen Teil eines vorgegebenen maximalen Hubes zwischen zwei Endpositionen, die mit einem elektrischen Antrieb versehen ist, dessen rotative Antriebsbewegung mittels einem Getriebe In translatorische Bewegungen transformierbar ist, sowie Betriebsdatenerfassungsmittel (18) zur Erfassung von Betriebsbelastungen und/oder Betriebszuständen der Linearantriebsvorrichtung aufweist, wobei die Betriebsdatenerfassungsmittel zur Datenerfassung an Stramanschlussmittel des elektrischen Antriebs anschliessbar sind, **gekennzeichnet durch** Mittel zur Speicherung von Daten, die auf einer Vielzahl von nacheinander erfolgenden Messungen der gleichen Messgrösse basieren, wobei die Messungen während des Einsatzes der Linearantriebsvorrichtung (14) in jeweils einem Lastzustand erfolgen.

2. Linearantriebsvorrichtung nach Anspruch 1, **gekennzeichnet durch** eine vom elektrischen Antrieb antreibbare Spindel (9) mit einem Aussengewinde in das eine Gewindemutter (10) eingreift, wobei die Gewindemutter (10) drehfest mit einem zum Anschluss an eine zu bewegende Last vorgesehenen Verbindungsteil wirkverbunden ist, wodurch der Verbindungsteil zu einer translatorischen Hin- und Herbewegungen zwischen zwei Endpositionen vorgesehen ist.

3. Linearantriebsvorrichtung nach zumindest einem der beiden vorhergehenden Ansprüche, **dadurch gekennzeichnet, dass** Daten von jeweils mehreren unterschiedlichen Messgrössen gespeichert werden, die sich vorzugsweise über eine Einsatzdauer erstrecken, in der eine Vielzahl von translatorischen Hin- und Herbewegungen des Verbindungsteils erfolgen.

4. Linearantriebsvorrichtung nach zumindest einem der vorhergehenden Ansprüche, **gekennzeichnet durch** eine Schnittstelle, über welche gespeicherte Daten zur Bestimmung der über einen bestimmten Zeitraum unter Last erfolgten Betriebsbelastung und/oder eines Betriebszustandes der Linearantriebsvorrichtung insbesondere berührungslos austauschbar sind.

5. Linearantriebsvorrichtung nach zumindest einem der vorhergehenden Ansprüche, **dadurch gekennzeichnet, dass** mit den Betriebsdatenerfassungsmittel Parameter des elektrischen Antriebs erfassbar sind.

6. Linearantriebsvorrichtung nach zumindest einem der vorhergehenden Ansprüche, **dadurch gekennzeichnet, dass** zur Ermittlung von Werten der zumindest einen Messgrösse Spannungswerte des elektrischen Antriebs gemessen und vorzugsweise gespeichert werden.

7. Linearantriebsvorrichtung nach zumindest einem der vorhergehenden Ansprüche, **dadurch gekennzeichnet, dass** mit dem Betriebsdatenerfassungsmittel (18) die Dauer von Betriebszeiten bestimmbar sind, während denen eine oder mehrere vorbestimmte Bedingungen erfüllt sind.

8. Linearantriebsvorrichtung nach Anspruch 7, **dadurch gekennzeichnet, dass** mit dem Betriebsdatenerfassungsmittel (18) eine Dauer bestimmbar ist, während der am elektrischen Antrieb eine Überspannung anliegt.

9. Linearantriebsvorrichtung nach zumindest einem der vorhergehenden Ansprüche, **gekennzeichnet durch** Addierungsmittel des Betriebsdatenerfassungsmittel, mit denen Werte von zumindest einer Messgrösse aufaddierbar sind.

10. Linearantriebsvorrichtung nach zumindest einem der vorhergehenden Ansprüche, **dadurch gekennzeichnet, dass** mit dem Betriebsdatenerfassungsmittel zumindest ein Maximalwert von zumindest einer vorgegebenen Messgröße erfassbar ist.

11. Linearantriebsvorrichtung nach zumindest einem der vorhergehenden Ansprüche, **gekennzeichnet durch** Mittel zur Bestimmung einer Gesamteinschaltzeit der Linearantriebsvorrichtung.

12. Linearantriebsvorrichtung nach zumindest einem der vorhergehenden Ansprüche, **dadurch gekennzeichnet, dass** mit dem Betriebsdatenerfassungsmittel eine (maximale) Einschaltzeit des elektrischen Antriebs bestimmbar ist, während der sich eine Welle des elektrischen Antriebs in nur eine Drehrichtung dreht.

13. Linearantriebsvorrichtung nach zumindest einem der vorhergehenden Ansprüche, **dadurch gekennzeichnet, dass** mit dem Betriebsdatenerfassungsmittel die Anzahl von Starts des elektrischen Antriebs erfassbar und Datenwerte hierzu speicherbar sind.

14. Linearantriebsvorrichtung nach zumindest einem der vorhergehenden Ansprüche, **dadurch gekennzeichnet, dass** die Betriebsdatenerfassungsmittel mit einem Mittel zur Erfassung von einem oder mehreren Temperaturwerten des elektrischen Antriebs und/oder von temperaturabhängigen Grössen des elektrischen Antriebs versehen ist.

15. Linearantriebsvorrichtung nach zumindest einem der vorhergehenden Ansprüche, **dadurch gekennzeichnet, dass** das Betriebsdatenerfassungsmittel mit Mitteln zur Unterscheidung von unterschiedlichen Bewegungsrichtungen der Abtriebswelle versehen ist.

16. Linearantriebsvorrichtung nach Anspruch 4, **dadurch gekennzeichnet, dass** die Schnittstelle eine optische Anzeige aufweist, mit der Daten in Form von Lichtsignalen wiedergebbar sind.

17. Linearantriebsvorrichtung nach zumindest einem der vorhergehenden Ansprüche, **gekennzeichnet durch** Mittel, mit denen eine Überspannung am elektrischen Antrieb bestimmbar ist.

18. Linearantriebsvorrichtung nach zumindest einem der vorhergehenden Ansprüche, **gekennzeichnet durch** Mittel zur Unterscheidung zwischen unterschiedlichen translatorischen Bewegungsrichtungen bei der Bestimmung der Betriebsbelastung und/oder des Betriebszustandes.

19. Linearantriebsvorrichtung nach zumindest einem der vorhergehenden Ansprüche, **gekennzeichnet durch** eine Manipulationssicherung des Betriebsdatenerfiassungsmittels, mit dem ein Zugriff auf Daten verhindert wird.

20. Linearantriebssystem umfassend eine Llnearantrlebsvorrlchtung (14) nach zumindest einem der vorhergehenden Ansprüche 1 bis 19 sowie eine Auswerteeinrichtung, der gespeicherte Daten der Betriebsdatenerfassungsmittel (18) von einer Vielzahl von Messungen zuführbar und durch die Auswerteeinrichtung auswertbar sind, wobei hierdurch mittels der Auswerteeinrichtung zumindest ein vom Benutzungsumfang und/oder von der Belastungshöhe abhängiger Parameter bestimmbar ist.

21. Möbel, insbesondere Medizinalmöbel wie Patientenbetten, Patientenlifter, Operationstischen, Verstelleinrichtungen zur Positionierung von medizinischen Geräten und dergleichen, **gekennzeichnet durch** eine Linearantriebsvorrichtung nach zumindest einem der vorhergehenden Ansprüche 1 bis 20.

22. Verfahren zur Bestimmung von Betriebsbelastungen und/oder Betriebszuständen einer Linearantriebsvorrichtung, die zur Ausführung von im wesentlichen geradlinigen Verstellbewegungen entlang einer Linearachse über zumindest einen Teil eines vorgegebenen maximalen Hubes zwischen zwei Endpositionen vorgesehen ist, hierbei eine rotative Antriebsbewegung eines elektrischen Antriebsmittels eines Getriebes in translatorische Bewegungen transformierbar ist, **dadurch gekennzeichnet, dass** während des Einsatzes der Linearantriebsvorrichtungen (14) in einem Lastzustand ermittelte Daten gespeichert werden, die im Zusammenhang mit eingetretenen Betriebsbelastungen und/oder Betriebszuständen der Linearantriebsvorrichtung (14) stehen, wobei die Daten auf einer Vielzahl von nacheinander erfolgenden Messungen der gleichen Messgrösse basieren.

23. Verfahren nach Anspruch 22, **dadurch gekennzeichnet, dass** Daten im wesentlichen über die gesamte vorgesehene Einsatzdauer, vorzugsweise über die gesamte Lebensdauer der Linearantriebsvorrichtung, erfasst werden.

24. Verfahren nach zumindest einem der beiden Ansprüche 22 und 23, **dadurch gekennzeichnet, dass** Daten von einer Motorspannung des elektrischen Antriebs der Linearantriebsvorrichtung während deren Einsatzdauer abgeleitet und abgespeichert werden.
